# EUROPEAN PATENT APPLICATION

(11) **EP 4 296 621 A1**
(43) Date of publication of application: **27.12.2023**
(21) Application number: 22305908.0
(22) Date of filing: 23.06.2022
(51) Int. Cl.: G01D 3/036, G01D 5/24

(54) **CAPACITIVE SENSOR DEVICE**

(71) Applicant: TE Connectivity Sensors France, 31027 Toulouse Cedex 3 (FR)
(72) Inventor: VILLEMIN, Francois-Xavier, Toulouse (FR); MATHIEU, Loic, Toulouse (FR); BIGOU, Nicolas, Toulouse (FR); GAUNARD, Florent, Toulouse (FR)
(74) Representative: Grünecker Patent- und Rechtsanwälte PartG mbB

(57) **Abstract**

The present invention relates to a capacitive sensor device comprising a printed circuit board, PCB, comprising first vias and first tracks connected with the first vias, a sensing device connected with the first vias of the PCB and compensation means configured for reducing a time-dependent parasitic capacity of the PCB between the first vias and/or between the first tracks.

## Description

### Field of Invention

The present invention relates to a capacitive sensor device for sensing a measurand, for example, properties of a fluid, and, in particular, a capacitive sensor device providing accurate measurements that are not significantly affected by temperature or humidity dependent parasitic capacities.

### Background of the invention

Sensors are of growing importance and become more and more ubiquitous in everyday life. Microelectromechanical systems (MEMS) are an attractive option to answer the demand for increased performances of sensors along with decreased sizes and costs. For example, temperature sensors, pressure sensors and humidity sensors or a combination thereof as well as sensors for detecting properties of fluids, for example, the viscosity, density or dielectric constant of oil, are known to be used in a large variety of applications.

Capacitive sensor devices represent a class of sensors that allow for relatively accurate measurements. For example, in the art, a humidity sensor device is known that comprises a dielectric substrate, two electrodes formed on the dielectric substrate and a sensitive layer for absorption and/or adsorption of water. A variation of capacitance caused by the absorption and/or adsorption of water can be measured and used for the determination of the (relative) humidity of an environment under the assumption that the water amount detected by the sensor is in thermal equilibrium with the gaseous fraction of water in the environment. Other capacitive sensor devices are configured for sensing measurands as temperature, pressure or properties of fluids, in general.

Usually, sensing elements of capacitive sensor devices are connected to printed circuit boards (PCBs) carrying or connected with analysis circuitries configured for receiving and processing input data provided by the sensing elements. Such PCBs provide parasitic capacities that may affect the accurateness of measurements made by the capacitive sensor devices. Constant parasitic capacities could be relatively easily compensated for by appropriate calibration of the capacitive sensor devices. However, in actual applications the parasitic capacities of the PCBs depend on the temperature and/or humidity of the measurement environment. Such time-dependent parasitic capacities may disadvantageously affect measurements in some unpredictable manner and, in particular, in the context of low-capacitance measurements within or below the pico Farad range may lead to wrong measurement results.

In view of the above, it is an object of the present invention to provide a capacitive sensor device that allows for a reliable sensing operation that is not significantly affected by a time-dependent parasitic capacity of the PCB comprised in the capacitive sensor device.

### Description of the Invention

The present invention addresses the above-mentioned object by providing a capacitive sensor device comprising a printed circuit board, PCB, comprising first vias and first tracks (traces) connected with the first vias, a sensing device (element) connected (by appropriate contacts) with the first vias of the PCB and compensation means configured for reducing a time-dependent parasitic capacity of the PCB between the first vias and/or between the first tracks. Herein, the term capacitive sensor device' covers any device comprising capacitive sensing elements and any device comprising sensitive elements which provide, possibly additional to main sensing data, capacities (wanted or parasitic) that can be used for the measurement of measurands. The PCB may be a multi-layer PCB. It is noted that the PCB may comprise or be connected with a microcontroller, a microprocessor, some application-specific integrated circuit (ASIC) and/or an application-specific standard product (ASSP) used for the analysis of measurement data and control of the operation of the capacitive sensor device.

The first vias and first tracks connected with the sensing device are crucial for a sensing operation of the capacitive sensor device. The time-dependent parasitic capacity of the PCB (which, for example, is made of or comprises an epoxy material) may, in particular, depend on the temperature and/or humidity of the environment of the capacitive sensor device.

According to the present invention, the capacitive sensor device comprises dedicated compensation means for reducing a time-dependent parasitic capacity of the PCB in regions between networks of first vias and/or tracks that are sensitive to the impact of a time-dependent parasitic capacity of the PCB such that measurements made by the capacitive sensor device would be significantly affected. Due to the provision of the compensation means the time-dependent parasitic capacity of the PCB can be significantly reduced and, thus, accurateness of capacitive measurements made by the capacitive sensor device can be improved as compared to sensor devices of the art.

According to an embodiment, the compensation means comprise or consist of second vias arranged in the PCB between the first vias and/or between the first tracks, wherein the second vias are connected with a source of a constant electrical potential, and second tracks arranged in the PCB and connected with the second vias. For example, a reliable source of a constant electrical potential that can suitably be provided is ground. The second tracks may be provided in each or some of the layers of a multi-layer PCB.

The second vias represent some stitching between first vias and/or between the first tracks that results in a division of the PCB material between the first vias and/or between the first tracks into relatively small portions that provide lower time-dependent overall parasitic capacities as compared to a time-dependent parasitic capacity provided by a non-stitched region of the PCB between the first vias and/or between the first tracks. By connection with the source of a constant electrical potential a well-defined capacity is provided that does not affect the measurements. The sensitive first vias and/or first tracks are screened/shielded against perturbations by the constant potential grid provided by the second vias and second tracks. In fact, a capacitance is provided between the grid and the first vias and/or first tracks but no voltage variation between the connections of the sensitive elements that would cause a time-dependent parasitic capacitance. By adding the biased (for example, grounded) grid made of second vias and second tracks, a separation (division) of electric field lines that otherwise would run from one sensitive element pin to another one is caused and, therefore, the equivalent parasitic capacitances variations that would result from such electric field lines without the compensation means in form of the biased grid can be substantially suppressed.

Experiments have proven that the accurateness of low capacity measurements can be significantly increased by provision of the grid of second vias and tracks. The grid of second vias and tracks can be easily formed by an appropriate masking during the production of the PCB. As compared to conventional PCBs used for sensor devices of the art, additional vias and tracks have to be formed which can be easily done at low costs in the context of mass production.

According to an alternative embodiment, the compensation means comprise or consist of one or more openings formed in the PCB between the first vias and/or between the first tracks. Due to the removal of the PCB material, according to this embodiment, a parasitic capacitance between the first vias and between the first tracks, respectively, depends on the dielectric constant of air.

As compared to the dielectric constant of the PCB (for example, epoxy) material the dielectric constant of air does only slightly depend on temperature and humidity and, therefore, does not show high fluctuations. Consequently, the parasitic capacitance governed by the openings can be relatively easily dealt with by appropriate calibration processing. It is noted that high-cost materials, for example, ceramic materials, may be used for the production of the PCB that also have dielectric constants that only slightly depend on temperature and humidity. However, usage of such high-cost materials would disadvantageously significantly increase the overall production costs of the capacitive sensor device. The compensation means in form of openings can be provided at low costs. For example, the openings can be formed by milling.

As already indicated above, the PCB may comprise an epoxy material (as a base substrate). The first vias may be formed in the epoxy material and the first tracks may be formed in or on the epoxy material. PCBs based on an epoxy material can be provided in mass production at low costs. Any disadvantages resulting from the sensitivity of the dielectric constant of the epoxy material against temperature and humidity can be compensated by the compensation means provided in accordance with the present invention. In particular, the compensation means described above may at least partially be formed in the epoxy material.

The problem of parasitic capacitances of PCBs of capacitive sensor devices is of particular relevance in the context of low capacitance measurements. Thus, the compensation means provided in accordance with the present invention may be particularly advantageous for low capacitance measurement applications. Thus, according to an embodiment, the capacitive sensor device is configured for sensing a capacitance of below one pico Farad (for example, in the femto Farad range).

The raw measurement data is provided by the sensing device of the capacitive sensor device that is electrically connected with the PCB of the capacitive sensor device by means of the first vias. The sensing device may be configured for contacting a fluid such that the capacitive sensor device can measure the property of that fluid.

According to an embodiment, the sensing device comprises sensing electrodes (for example, interdigitated electrodes) and a sensing layer, the sensing electrodes and the sensing layer forming a capacitor. The sensing device may comprise a substrate over or on which the sensing layer is formed. At least one of the sensing electrodes might be formed over the substrate, in particular, over the sensing layer. An adhesion layer (made of chromium, for example) that insures a stable adhesion of the electrodes to the substrate can also be deployed. The sensing layer, for example, exhibits a capacitance formed between the sensing electrodes that varies depending on the quantity of a measurand (for example, temperature, pressure, humidity, viscosity or dielectric constant/permittivity). The sensing layer may be an organic or inorganic dielectric layer, for example, exhibiting a well-defined adsorption/absorption rate for water, and at least one of the sensing electrodes may be formed on or over the sensing layer. The inorganic dielectric layer can be made of or comprise a nitride material, in particular, Si3N4 or silicon carbide.

In principle, the capacitive sensor device may be configured for sensing temperature, pressure, relative or absolute humidity or a combination thereof. According to a particular embodiment, the capacitive sensor device is configured for sensing a property, in particular, a viscosity, density, dielectric constant or contaminants, of a fluid (liquid or gas). The fluid may be oil, for example, a lubricant oil, a transmission oil, a gearbox oil, an engine oil, etc. or the fluid may be, for example, an automotive fluid as fuel or a coolant, etc. The fluid may be air.

Furthermore, it is provided a method of sensing a property of a fluid by means of a capacitive sensor device according to one of the above-described embodiments, comprising contacting the sensing device of the capacitive sensor device with the fluid. The fluid may be oil or an automotive fluid as fuel or a coolant, etc. and the property may be at least one of density, viscosity, temperature, dielectric constant and contaminants.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figure 1 illustrates the problem of parasitic capacitance provided by a PCB of a capacitive sensor device.
Figure 2 illustrates a capacitive sensor device comprising compensation means according to an embodiment.
Figure 3 is a top view of a part of a PCB of a capacitive sensor device comprising stitching between sensitive vias according to an embodiment.
Figure 4 is a top view of a part of a PCB of a capacitive sensor device comprising stitching between sensitive tracks according to an embodiment.
Figure 5 illustrates a capacitive sensor device comprising compensation means in form of a screening/shielding grid formed in a PCB of the capacitive sensor device according to an embodiment.
Figure 6 illustrates a capacitive sensor device comprising compensation means in form of an opening formed between sensitive vias of a PCB of the capacitive sensor device according to an embodiment.

The present invention provides a capacitive sensor device comprising compensation means for reducing a time-dependent parasitic capacity of a PCB of the capacitive sensor device between sensitive vias and/or tracks of the PCB such that accurateness of measurements made by the capacitive sensor device are not significantly affected by parasitic capacities. The provided configuration can be easily produced by mass production semiconductor manufacturing processes. It can be manufactured at relative compact sizes and low costs.

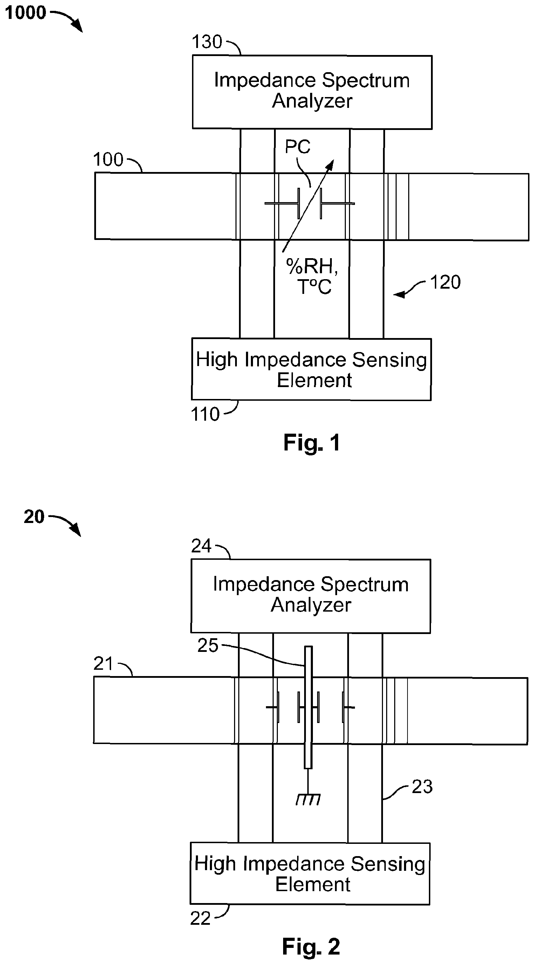

Figure 1 illustrates the problem of a time-dependent parasitic capacitance provided by a PCB of a capacitive sensor device which is addressed by the present invention. Figure 1 shows a capacitive sensor device 1000 comprising a PCB 100. A sensing device (element) 110 is connected with the PCB 100 via contacts 120 soldered to vias formed in the PCB 100. Further, an analysis (sensing) circuitry 130 is connected with the PCB 100. Electric currents flowing through the contacts 120 and vias cause a parasitic capacitance PC between the vias in the PCB 100. This parasitic capacitance PC depends on the temperature and humidity of the environment of the capacitive sensor device 1000. The thus resulting time-dependent parasitic capacitance PC affects accurateness of measurements made by the capacitive sensor device 1000. In the following solutions of this problem in accordance with the present invention are described.

Figure 2 exemplarily shows an embodiment of a capacitive sensor device 20 according to the invention. The capacitive sensor device 20 comprises a PCB 21, for example, a multi-layer PCB 21. A sensing device (element) 22 is connected with the PCB 21 by means of contacts 23 soldered to first vias formed in the PCB 21 that are connected with a sensing device (not shown in Figure 2). A measurand of a medium is sensed by means of the sensing device 22. Further, an analysis (sensing) circuitry 24 is connected with the PCB 21.

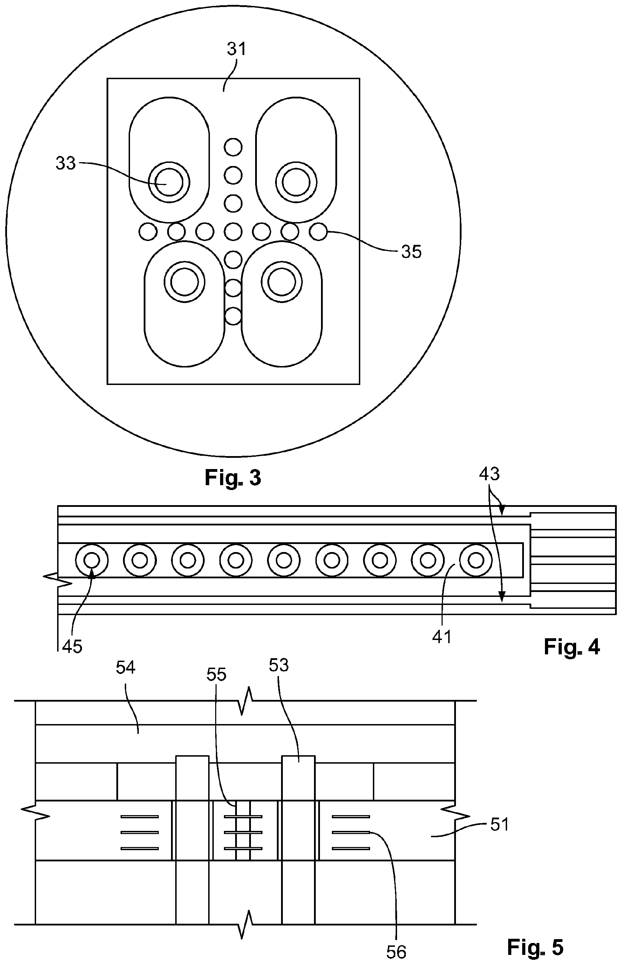

The capacitive sensor device 20, additionally, comprises compensation means configured for reducing a time-dependent parasitic capacity of the PCB 21 between the first vias in the PCB 21. In the configuration shown in Figure 1, the compensation means comprise second vias 25 formed in the PCB 21 between the first vias. The second vias 25 are connected to ground (or another source of a constant electrical potential). Figure 3 is a top view of a configuration similar to the one shown in Figure 2. First vias 33 are formed in a PCB 31. Second vias 35 similar to the second via 25 shown in Figure 2 are formed in a region of the PCB 31 between the first vias 33. The second vias 35 represent a stitching of the region of the PCB 31 between the first vias 33. By this stitching the region of the PCB 31 between the first vias 33 is divided into smaller parts which results in a reduction of the overall time-dependent parasitic capacity of the PCB 21 in that region. Similarly, stitching can be provided between sensitive tracks as it is illustrated in Figure 4. Figure 4 is a top view of a configuration comprising tracks (traces) 43 formed on a layer of a multi-layer PCB 41. The tracks 43 are connected with vias (for example, such as the first vias 33 shown in Figure 3) that in course are connected with a sensing device. The layer can be a top layer or some intermediate layer of the multilayer PCB 41. The stitching is realized by (second) vias 45.

The configurations shown in Figures 2, 3 and 4, furthermore, comprise additional (second) tracks connected with the second vias 35, 45. For example, Figure 5 shows a configuration similar to the one shown in Figure 2. The configuration shown in Figure 5 comprises a PCB 51. Contacts 53 are connected to corresponding first vias formed in the PCB 51 and extend to an analysis circuitry 54. Between the first vias second vias 55 are formed. The second vias 55 are connected with (second) tracks 56 that are formed in layers of the multiple-layer PCB 51. Further, the second vias 55 are connected to ground (see also Figure 2). The second vias 55 connected to ground and the (second) tracks 56 form a screening/shielding grid that protects sensitive first vias 33 and first tracks 43 (see Figures 3 and 4) against fluctuating parasitic capacitances.

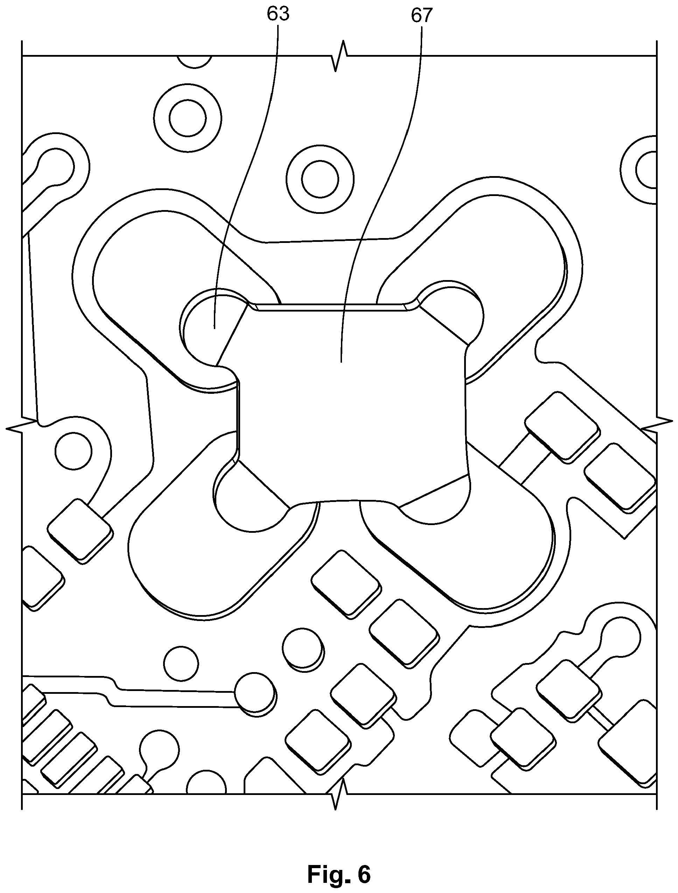

An alternative embodiment of the inventive capacitive sensor device provided herein is illustrated in Figure 6. Vias 63 (similar to the vias 33 shown in Figure 3) are formed in a PCB 61 of the capacitive sensor device. The vias are connected by means of contacts to a sensing device (not shown in Figure 6). An opening 67 is milled into the PCB 61 in a region between the vias 63. It is noted that by the milling process the portions of the barrels of the vias 63 extending from the board for contacting are reduced in width. Since the material of the PCB 61 is removed between the vias 63 no parasitic capacity can be provided by that material. Rather, air in the opening represents a parasitic capacitor dielectric. However, the dielectric constant of air, as compared to the dielectric constant of the PCB material (for example, an epoxy material), does almost not depend on the temperature and humidity of the environment of the capacitive sensor device. Therefore, air between the vias 63 provides for an almost constant parasitic capacitance that can be compensated by appropriate calibration of the capacitive sensor device.

Providing the same effect, openings like the opening 67 shown in Figure 6 may also be formed between sensitive tracks, for example, between tracks running in parallel to each other as the tracks 43 shown in Figure 4.

In the above-described configurations, the PCB may comprise an epoxy material (as a base material) and the first and/or second vias may comprise copper barrels and the first and/or second tracks may be made of copper, for example.

The above-described embodiments of a capacitive sensor device may be used for sensing a large variety of measurands including temperature, pressure, relative and absolute humidity, viscosity, dielectric constant, contaminants etc. and combinations thereof. For example, the capacitive sensor device can be a fluid sensor device for sensing properties of a fluid, for example, oil. Such a capacitive sensor device may be used for sensing the properties (for example, viscosity, density, dielectric constant and/or contaminants) of fuel or a coolant or transmission oil, gearbox oil, engine oil or lubricant oil (for example, used in an aircraft or automobile). For example, the degradation of such oils due to contamination by particles may be determined by means of such a capacitive sensor device, since contaminants alter the dielectric constant of the oil and thereby sensed capacitances. In automotive applications, the capacitive sensor device may be configured to be connected with a CAN bus for data transmission.

All previously discussed embodiments are not intended as limitations but serve as examples illustrating features and advantages of the invention. It is to be understood that some or all of the above described features can also be combined in different ways.

### Reference Numbers

- 20, 1000:: capacitive sensor device
- 21, 31, 41, 51, 61, 100:: PCB
- 22, 110:: sensing device
- 23, 53, 120:: contacts
- 24, 130:: analysis circuitry
- 25, 35, 45, 55:: second vias
- 33, 63:: first vias
- 43:: first tracks
- 56:: second tracks
- 67:: opening

## Claims

1. Capacitive sensor device (20), comprising
a printed circuit board, PCB, (21, 31, 41, 51, 61) comprising first vias (33, 63) and first tracks (43) connected with the first vias (33, 63);
a sensing device (22) connected with the first vias (33, 63) of the PCB (21, 31, 41, 51, 61); and
compensation means configured for reducing a time-dependent parasitic capacity of the PCB (21, 31, 41, 51, 61) between the first vias (33, 63) and/or between the first tracks (43).

2. The capacitive sensor device (20) according to claim 1, wherein the compensation means comprise
second vias (25, 35, 45, 55) arranged in the PCB (21, 31, 41, 51, 61) between the first vias (33, 63) and/or between the first tracks (43), wherein the second vias (25, 35, 45, 55) are connected with a source of a constant electrical potential; and
second tracks (56) arranged in the PCB (21, 31, 41, 51, 61) and connected with the second vias (25, 35, 45, 55).

3. The capacitive sensor device (20) according to claim 2, wherein the source of a constant electrical potential is ground.

4. The capacitive sensor device (20) according to claim 1, wherein the compensation means comprise or consist of one or more openings (67) formed in the PCB (21, 31, 41, 51, 61) between the first vias (33, 63) and/or between the first tracks (43).

5. The capacitive sensor device (20) according to claim 1, wherein the time-dependent parasitic capacity of the PCB (21, 31, 41, 51, 61) depends on temperature and/or humidity of the environment of the capacitive sensor device (20).

6. The capacitive sensor device (20) according to one of the preceding claims, wherein the PCB (21, 31, 41, 51, 61) comprises an epoxy material and the first vias (33, 63) are formed in the epoxy material and the first tracks (43) are formed in or on the epoxy material.

7. The capacitive sensor device (20) according to claim 6, wherein the compensation means are at least partially formed in the epoxy material.

8. The capacitive sensor device (20) according to one of the preceding claims, wherein the capacitive sensor device (20) is configured for sensing a capacitance of below one pico Farad.

9. The capacitive sensor device (20) according to one of the preceding claims, wherein the sensing device (22) is configured for contacting a fluid.

10. The capacitive sensor device (20) according to one of the preceding claims, wherein the sensing device (22) comprises sensing electrodes and a sensing layer, the sensing electrodes and the sensing layer forming a capacitor.

11. The capacitive sensor device (20) according to one of the preceding claims, wherein the capacitive sensor device (20) is configured for sensing temperature, pressure, relative or absolute humidity or a combination thereof.

12. The capacitive sensor device (20) according to one of the preceding claims, wherein the capacitive sensor device (20) is configured for sensing a property, in particular, a viscosity, density, dielectric constant or contaminants, of a fluid, in particular, a property of an automotive fluid, fuel, a coolant or oil.

13. Method of sensing a property of a fluid by means of a capacitive sensor device (20) according to one of the preceding claims, comprising contacting the sensing device (22) of the capacitive sensor device (20) with the fluid.

14. The method according to claim 13, wherein the fluid is an automotive fluid, fuel, a coolant or oil and the property is at least one of viscosity, density, temperature, a dielectric constant and contaminants.
